Europäisches Patentamt

European Patent Office

Office européen des brevets

(19)

(11) Publication number: **0 206 518**
**A2**

# (12) EUROPEAN PATENT APPLICATION

(21) Application number: **86303846.9**

(22) Date of filing: **21.05.86**

(51) Int. Cl.⁴: **G 01 R 13/22**

(30) Priority: **20.06.85 US 746815**

(43) Date of publication of application: **30.12.86**
**Bulletin 86/52**

(84) Designated Contracting States: **DE FR GB NL**

(71) Applicant: **TEKTRONIX, INC., Tektronix Industrial Park D/S Y3-121 4900 S.W. Griffith Drive P.O. Box 500, Beaverton Oregon 97077 (US)**

(72) Inventor: **Bowne, John D., 8620 SW Monticello Street, Beaverton Oregon 97005 (US)**
Inventor: **Larson, Lester L., 1425 N.W 87th Avenue, Portland Oregon 97229 (US)**

(74) Representative: **Wombwell, Francis et al, Potts, Kerr & Co. 15, Hamilton Square, Birkenhead Merseyside L41 6BR (GB)**

(54) Vertical raster scan controller.

(57) Images of one or more digitized waveforms are displayed on a vertical raster scan cathode ray tube screen. Vertical scan lines, comprising strings of pixels, represent sampling periods and each pixel along the raster scan line represents a different waveform magnitude level. A pixel count is maintained as each raster line is scanned upward and when the count reaches the value of the smaller of digitized waveform magnitude data pair acquired at the beginning and at the end of a sampling period, the next higher scanned pixels assume a color different than a background pixel color. When the count reaches a number equaling the higher of the acquired sample data, the raster scan is changed again so that the next scanned pixels assume the same color as the screen background color. Thus each waveform image comprises a set of contiguous vertical raster scan line segments. Means are also provided for selectivity generating a bit mapped display superimposed on, or replacing portions of the waveform image.

# VERTICAL RASTER SCAN CONTROLLER

## Background of the Invention

The present invention relates in general to oscilloscopes and in particular to a method and apparatus for controlling a vertical raster scan cathode ray tube for high speed display of ordinate data as a function of a monotonic abscissa value.

Oscilloscopes commonly employ two methods to display a waveform on a cathode ray tube screen. In a deflected beam method, an electron beam scans horizontally across the screen at a constant rate while it is deflected in a vertical direction by a potential proportional to the magnitude of the waveform. In a bit-mapped raster scan method, the waveform is digitized and converted into pixel data stored in a random access memory. The screen is divided into pixels and each stored pixel data word corresponds to one pixel on the screen. An electron beam scans the screen in horizontal lines from top to bottom turning on and off to light pixels on the screen according to the stored pixel data, thereby creating the waveform image.

Deflected beam oscilloscopes typically update faster than bit-mapped raster scan oscilloscopes and are therefore usually more suitable in real time applications. However raster scan oscilloscopes permit indefinite storage of the waveform while deflected beam oscilloscopes usually do not. Also, on-screen graphics, such as data indicating waveform amplitudes, oscilloscope control settings, and menus, are easier to implement utilizing bit-mapped oscilloscopes with better resolution than can normally be obtained utilizing a deflected beam oscilloscope.

0206518

What would be desirable would be a method and apparatus for displaying a waveform on a cathode ray tube which permits indefinite storage of the waveform, rapid update of the display, and concurrent display of high resolution graphics on the screen.

## Summary of the Invention

According to one aspect of the invention, an oscilloscope employs a vertical raster scan display method wherein an electron beam in a cathode ray tube rapidly scans a screen in a vertical direction as it more slowly scans the screen in the horizontal direction so that the screen is scanned in a set of vertical raster scan lines. The beam turns on and off as it scans each vertical scan line so that an image on the screen comprises a set of vertical line segments.

According to another aspect of the invention, an image to be displayed on the screen is digitized and stored in a random access memory as a set of number pairs. Each vertical scan line is divided into pixels and one number in each pair indicates the pixel position along a vertical raster scan line where the beam is to turn on and the other number of the pair indicates the pixel position where the beam is to turn off. A data pair corresponding to a vertical line segment is read out of the random access memory at the start of each vertical scan and placed in registers. A counter generates a pixel count as the vertical line is scanned and the count is compared with the data in the registers. When the count reaches the lowest number of the data pair, the beam turns on, and when the count reaches the highest number of the

3 0206518

data pair, the beam turns off.

This method permits indefinite storage of the waveform image in the form of data in a random access memory, as does the bit-mapped raster scan method, but allows faster display update. The bit-mapped method requires that the state of each of a large number of pixels along each vertical raster scan line be computed and written into memory before the display is updated. In contrast, the present invention requires only two data points along each vertical raster scan line for each waveform be digitized and stored in memory between each screen update.

According to a further aspect of the invention, the beam may also be turned on and off according to data stored in a random access bitmapping memory so that a graphics display may be superimposed on the screen over the waveform display or inserted as a window in a portion of the display. The bit map is used for graphical display of oscilloscope control menus, settings and other purposes and is loaded prior to waveform sampling and therefore does not degrade waveform display update speed.

It is therefore an object of the present invention to provide a new and improved method and apparatus for controlling an oscilloscope display permitting rapid update of sampled waveform images.

It is another object of the present invention to provide a new and improved method and apparatus for controlling an oscilloscope display permitting display of high resolution graphics on an oscilloscope screen in conjunction with sampled waveform images.

It is a further object of the present invention to provide a new and improved method and apparatus for controlling an oscilloscope display permitting indefinitely long display of an image of a sampled waveform on the oscilloscope screen.

The subject matter of the present invention is particularly pointed out and distinctly claimed in the concluding portion of this specification. However, both the organization and method of operation, together with further advantages and objects thereof, may best be understood by reference to the following description taken in connection with accompanying drawings wherein like reference characters refer to like elements.

### Drawings

FIG. 1 is a block diagram of a sampling oscilloscope system employing the present invention;

FIG. 2 is an illustration of a typical waveform to be sampled by the oscilloscope system of FIG. 1;

FIG. 3 is an illustration of the digitization of the waveform of FIG. 2;

FIG. 4 is an illustration of an image of the waveform of FIG. 2 as would be displayed by the oscilloscope system of FIG. 1;

FIG. 5 is an illustration of the various display areas of the CRT screen of FIG. 1;

FIG. 6 is a block diagram of the vertical raster scan controller of FIG. 1;

FIG. 7 is a block diagram of the waveform register of FIG. 6;

FIG. 8 is a block diagram of the combinational logic circuit of FIG. 6;

FIG. 9 is a block diagram of the priority control circuit of FIG. 6;

FIG. 10 is a block diagram of the clipper circuit of FIG. 6; and

FIG. 11 is a block diagram of the comparator circuit of FIG. 6.

## Detailed Description

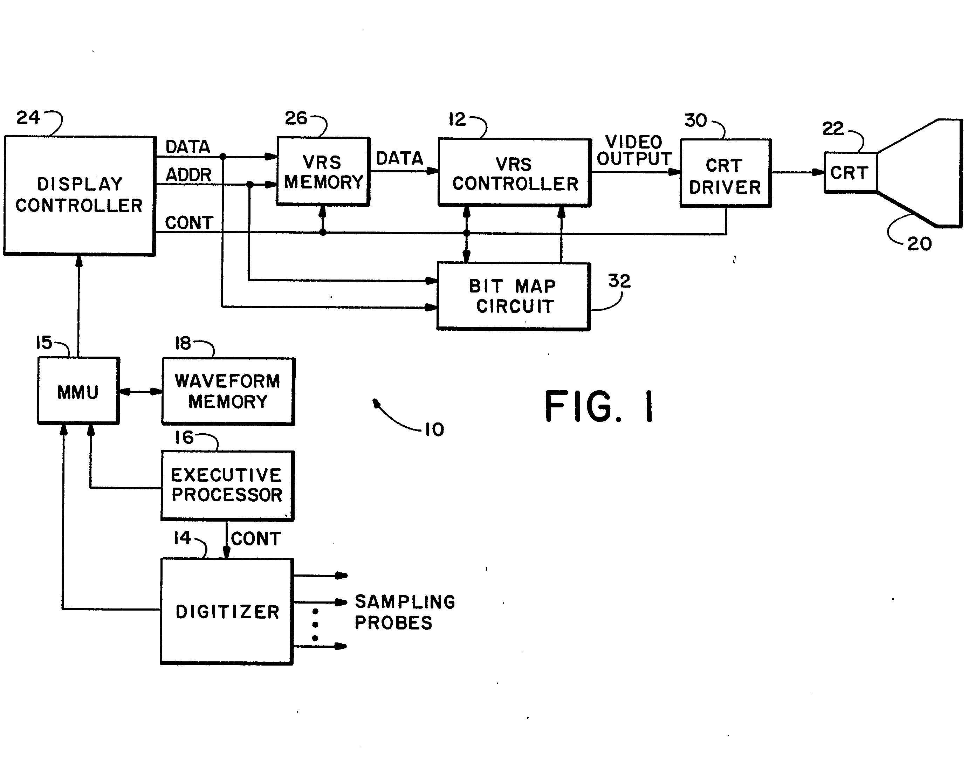

Referring to FIG. 1, there is depicted in block diagram form, an oscilloscope system 10 employing a vertical raster scan controller 12 according to the present invention. The oscilloscope system 10 is adapted to permit standard (Y-t) waveforms to be displayed on a vertically scanned CRT 22. A digitizer 14, samples and digitizes up to eight analog voltage waveforms at regular intervals and transmits digitized waveform data to a memory management unit (MMU) 15 which stores the sample data in a random access waveform memory 18.

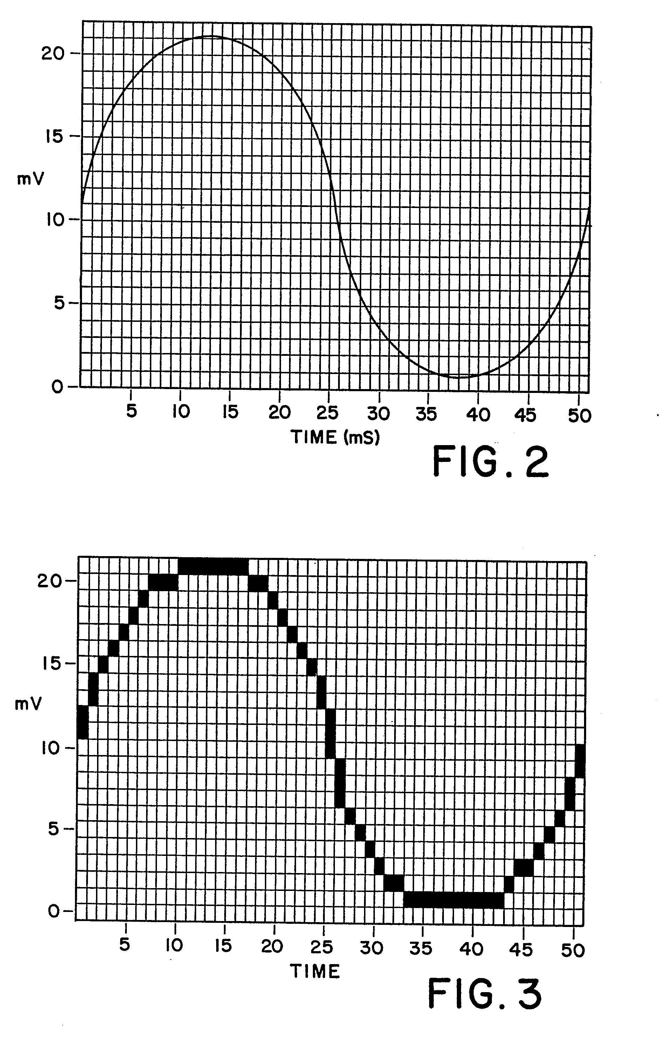

A typical sampled waveform is depicted in FIG. 2. The voltage of the waveform is scaled along the vertical axis while time is scaled along the horizontal axis. Vertical grid lines bound sampling intervals while horizontal grid lines represent measurable voltages. For purposes of illustration the digitizer 14 is assumed to have a measurement resolution of 1 mV and a sampling period of 1 mS although digitizers having other resolutions and sampling periods may be used. The waveform is sampled at the beginning of each sampling interval. In the instant case the digitizer output data at the beginning of sampling interval 1 would indicate that the magnitude of the waveform is 11 mV while the digitizer output data at the beginning of sampling interval 2 would be 13 mV. A plot of the digitized data samples acquired along the waveform of FIG. 2 is shown in FIG. 3. The horizontal rows of small rectangles represent voltage levels while the vertical columns represent sampling intervals. A darkened rectangle indicates the magnitude of the digitizer output at the beginning of the sampling interval.

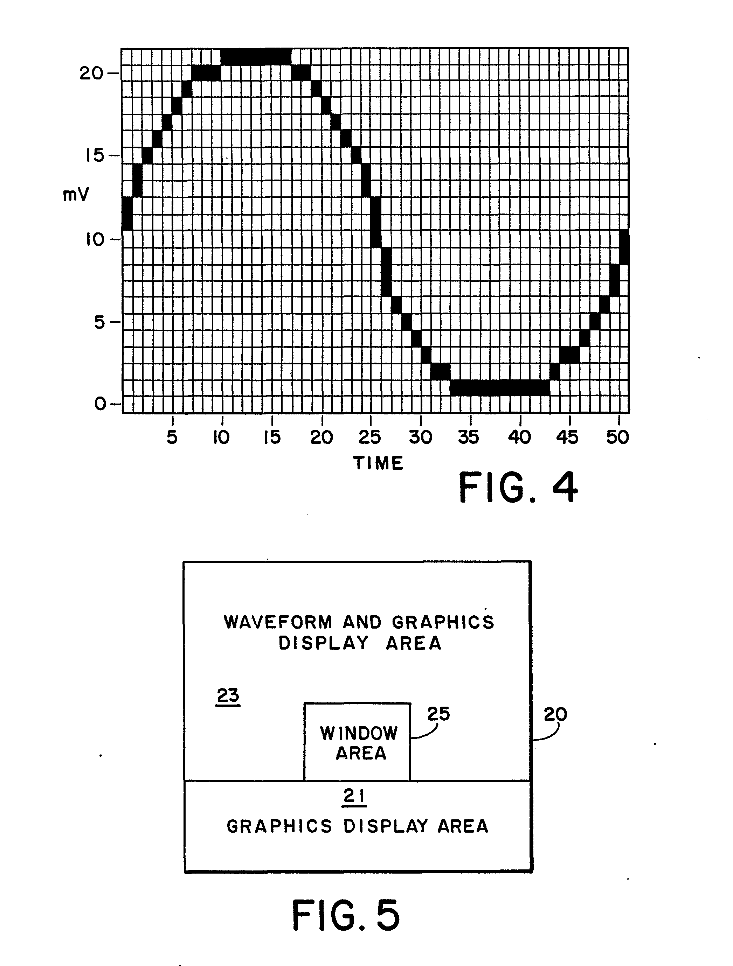

According to the present invention, an image of the sampled waveform of FIG. 2 is displayed on a cathode ray tube (CRT) 22 screen 20 of FIG. 1. A portion of the screen 20 is illustrated in FIG. 4. The displayed image is created using the acquired sampling data of FIG. 3. The screen 20 is divided into rows and columns of pixels, as represented by the small squares in FIG. 4, each pixel column corresponding to one sampling interval and each pixel row corresponding to one mV division. The CRT is of the vertical raster scan type wherein an electron beam is rapidly scanned in the vertical direction (the raster scan) and more slowly scanned in the horizontal direction (the field scan) so that pixels are scanned from bottom to top one column at a time.

Two voltage measurements are associated with each sampling interval, one taken at the beginning and one taken at the end. When the beam is at the bottom of a column, it is off so that no pixels are illuminated. As the beam scans towards the top of a column it reaches a pixel row corresponding to the lower of the two sampled voltage levels associated with the sampling interval. At this point the beam is turned on and begins to illuminate pixels as it continues to scan upwards. When the beam reaches a pixel row corresponding to the higher of the two voltage levels, the beam turns off so that no more pixels are illuminated as it continues to scan upward. When this procedure is

0206518

repeated for every vertical scan the resulting image appears as in FIG. 4. The horizontal resolution of the image can be improved by increasing the sampling rate of the digitizer 14 so that the image covers a broader expanse of the display.

Referring again to FIG. 1, the scanning rate and resolution of the digitizer 14 are controlled by an executive processor 16 in response to input from a user. Acquisition memory 18 stores the sample data output of the digitizer 14 generated between screen 20 refresh operations. The memory management unit 15 then transfers the data to a display controller 24 for subsequent storage in a vertical raster scan (VRS) memory 26 prior to a screen 20 refresh operation. During a refresh operation, controller 24 addresses VRS memory 26 prior to each vertical scan, causing it to transmit a pair of sample data words to a VRS controller 12 for each of the eight waveforms sampled by digitizer 14. VRS controller 12 generates a VIDEO OUTPUT control signal to a CRT driver 30 which controls the vertical and horizontal scanning of the beam in CRT 22. The VIDEO OUTPUT control signal from the VRS controller 28 tells the CRT driver when to turn on and off the beam during each vertical scan.

The sampling oscilloscope 10 is also adapted to display on screen 20 graphics and text data, such as graphical "pushbuttons" indicating where an operator should touch the screen 20 to change oscilloscope operating parameters. In the preferred embodiment, infrared scanners around the rim of the screen 20 sense the position on the screen at an operator's finger. Referring to FIG. 5, these graphical pushbuttons are displayed at the bottom of the screen 20 in a graphics display area 21 or

8

0206518

superimposed on a waveform in a waveform/graphics display area 23. Superimposed graphics in area 23 may also include grid lines, labels, data or other useful graphics. Data or graphical material may also be displayed on screen 20 in "pop-up" windows such as window 25, temporarily replacing any waveform images that might otherwise appear in the same portion of display area 23.

Referring to FIG. 1, the display is memory mapped by a conventional bit mapping circuit 32, each pixel in display 20 corresponding to a separate data word stored in a random access memory within bit map circuit 32. The stored data determines the on/off or color state of the corresponding pixel. Prior to a screen 20 update operation, display controller 24 loads pixel data into bit map circuit 32 to bit map the desired text and graphical display data, as determined by user selections. Prior to the start of each vertical raster scan, display controller 24 causes bit map circuit 32 to read out and transmit to the VRS controller 12 all of the bit map data corresponding to the pixels of the vertical scan line. If the pixel data is non-zero, then this data controls the VIDEO OUTPUT signal of VRS controller 12, and the waveform display data provided to the VRS controller 12 from the VRS memory 26 has no effect on the VIDEO OUTPUT signal.

During the first part of a vertical scan, much of the corresponding bit map circuit 32 pixel data is non-zero because the lower graphics portion 21 of screen 20 in FIG. 5 normally comprises a graphical display. As the scan reaches the top of the graphics area 21, any bit map graphics are normally superimposed on the waveform unless the graphics are included in a window 25. If the raster scan line is included in a window, the bit mapped pixel data alone will control the VIDEO OUTPUT signal with the waveform image resulting from the VRS memory 26 data being suppressed until the scan reaches the top of the window. Above the top of a window the VRS memory 26 waveform data will not be suppressed so that the upper portion of the screen 20, display area 23, will display the waveform along with any superimposed bit mapped graphics.

Referring to FIG. 1, the digitizer 14 samples all eight waveforms simultaneously and sends a series of eight data words to waveform memory 18 at the start (or end) of each sampling interval. As display controller 24 acquires sample data from waveform memory 18, it adds different color indicating bits to the data associated with each waveform prior to storing the data in VRS memory 26. If three color indicating bits are used, eight different colors are possible. Since one color must be the background color, the waveform images may be seven different colors. Different waveforms may share the same color. VRS controller 12 includes a color table to convert the color bits to the appropriate color producing VIDEO OUTPUT signal. Each color is assigned a relative priority so that when two or more sampled waveform images try to use the same pixel on display 20, only one waveform image controls the color of the pixel.

The display controller 24 also stores a number of "inhibit" bits in each memory location of VRS memory 26 containing data associated with each waveform sample. An "age" inhibit bit indicates whether the associated waveform data has been acquired since the last screen 20 update. The display is updated on a regular basis regardless of the sampling rate of the digitizer 14. If the digitizer 14 sampling rate is low, then the display will be updated more than once during the time it takes the digitizer to completely digitize the portion of a waveform being displayed. One age bit is stored in VRS memory 26 with each sampling data word. If the data obtained at one end of a sampling period is old, while the data obtained at the other end of the sampling period is new, the age bits do not match and the stored sample data is not used to control activation of the pixels in the display column associated with the sampling period. This leaves a one pixel wide gap in the displayed waveform image, thereby preventing an erroneous display due to data at opposite ends of a sampling interval being obtained between different update cycles.

At the beginning of each waveform data acquisition operation, executive processor 16 stores a special "null" code at every waveform memory 18 location, and this data remains stored therein until replaced by sample data from digitizer 14. If a display update is initiated before the null data in memory 18 is replaced, the null code is sent to display controller 24 and stored in VRS memory 26. Display controller 24 is adapted to identify the null code and to store a "null" inhibit bit in VRS memory 26 along with each sample data word to indicate whether the stored data is null. If the null bit is set for either the starting or ending sample interval data points of a waveform, the waveform display for the corresponding sampling interval is suppressed.

If the magnitude of a sampled waveform is outside the range of digitizer 14, the digitizer generates an overrange or an underrange code instead of sample data and that code is stored as sample data in the waveform memory 18. When this data is sent to display controller 24 during a screen update operation, it recognizes the codes and sets on "overrange" or an "underrange" inhibit bit which is stored with each sample data word to indicate that the waveform magnitude exceeds the upper or lower limits of the digitizer. At the same time, the underrange code is converted to a number representing the lower limits of the display prior to storage in memory 26 as "sample data" for the sampling interval. Similarly the overrange code is converted to a number representing the upper display limit. VRS controller 12 uses the inhibit bits to determine how to use the data when generating the VIDEO OUTPUT signal.

When both overrange bits or both underrange bits associated with the sample data for the start and the end of a sampling interval are set, the display for the sampling interval is suppressed. When only the lower of two data points at two data points associated with a sampling interval has a set underrange bit, the raster line for the waveform is displayed but clipped at its lower limit. Similarly, when only the larger of the two sample points has an overrange indicating bit set, the raster line for the waveform is displayed but is clipped at the upper limit.

The display controller 24 groups waveform data into pairs corresponding to samples taken at the beginning and end of each sample period and stores each sample pair at a separate address in VRS memory 26, along with the associated color indi-

0206518

cating and inhibit bits. Each vertical raster scan thus requires eight storage locations in VRS memory 26 to store the data associated with the eight waveforms. The display controller 24 uses one additional VRS memory 26 storage location for each vertical raster scan line to store a "clipping" data word. The clipping data indicates to VRS controller 12 the pixel elevation along a vertical raster scan line at which the graphical display area 21 or a pop-up window 23 ends.

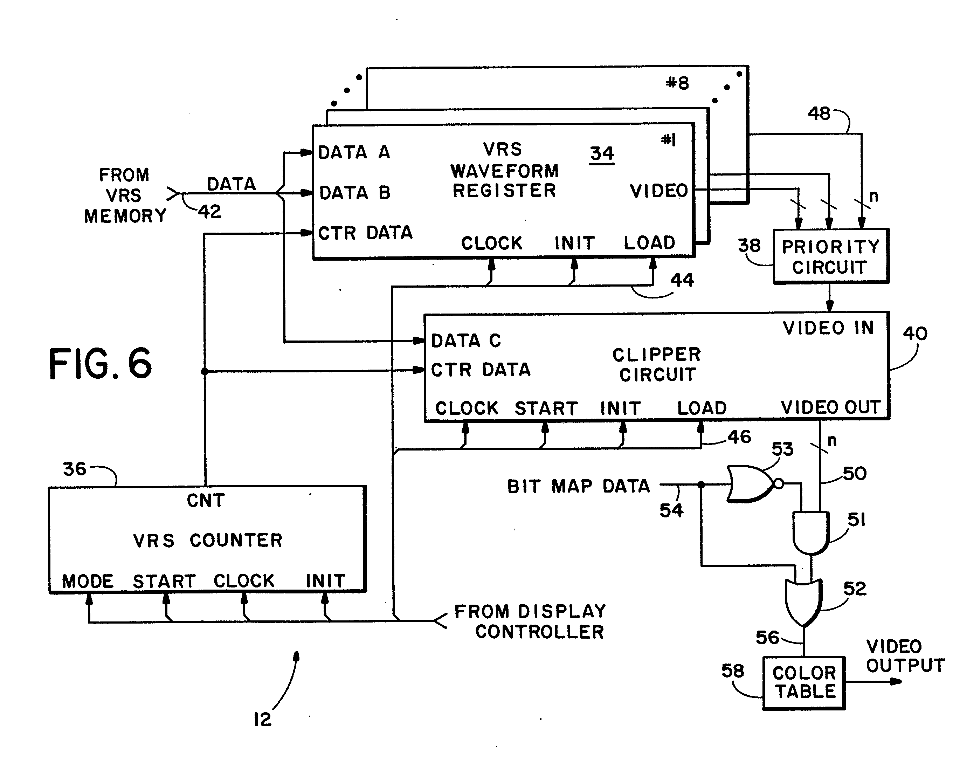

The VRS controller 12, depicted in block diagram form in FIG. 6, comprises a set of eight VRS waveform registers 34 (one corresponding to each of the sampled waveforms), a VRS counter 36, a priority controller circuit 38, and a VRS clipper circuit 40.

Each of the eight sample data pairs associated with each sampling interval is stored at eight different addresses in VRS memory 26. Each pair includes a data word A and a data B word with either the A or B data word indicating the magnitude of a sampled waveform at the start of a sampling interval, and with the other word indicating the magnitude of the waveform at the end of a sampling interval. The clipping data word C associated with each sampling interval is stored at a ninth address. Prior to the start of a vertical scan, display controller 24 accesses the nine VRS memory 26 storage locations, causing each of the eight A and B data pairs and the clipping data C associated with the vertical scan line to be sequentially read and placed onto a data output bus 42 connected in parallel to data A and B inputs of each VRS waveform register 34 and to a data C input of clipper circuit 40. When the A and B pair data associated with the first waveform is on bus 42, the display controller 24 asserts a load control line 44 to the first VRS waveform register 34, causing only that waveform register to store the A and B pair data on the bus 42. Similarly, as A and B pair data associated with other sampled waveforms appear on data output bus 42, the display controller 24 causes the data to be stored in the appropriate waveform register 34 by asserting a separate load control signal applied to each register. When the clipping data C appears on the data bus 42, the display controller asserts another load control line 46 to clipper circuit 40 causing the clipper circuit to store the clipping data word C.

When all of the VRS registers 34 are loaded with the A and B data pairs, and the clipping circuit 40 is loaded with the clipping data, the display controller 24 asserts an INIT line to the VRS counter 36 to reset a current count to zero, and to each VRS waveform register 34 and clipper circuit 40 to reset comparators therein. Then the display controller 24 transmits a vertical synchronizing signal to the CRT driver 30 of FIG. 1 to increment the horizontal position of the beam by one pixel and to initiate the vertical scan. The CRT driver 30 then moves the beam in the vertical direction along screen 20 by one pixel each time it detects an applied CLOCK pulse generated by the display controller 24.

In the preferred embodiment, the area of screen 20 which may be controlled by the VRS controller 12 is 512 pixels high and includes all of waveform display area 23 of FIG. 5 and an upper portion of graphical area 21 if display area 23 is less than 512 pixels high. When the scan reaches the lower limit of the 512 pixel VRS display area of screen 20, the display controller 24 transmits a START control signal to the VRS counter 36 causing the counter to begin counting the CLOCK pulses generated by the display controller 24. The current VRS counter 36 CLOCK pulse count (CNT) thus indicates the number of pixels that the beam scanned upward since the start of the VRS display area. The current pixel count is transmitted to a CTR DATA input of each VRS waveform register 34 and a CTR DATA input of the clipper circuit 40.

The CLOCK pulse signal is also applied to each VRS waveform register 34. When the current pixel count matches the magnitude of the smallest of the A or B waveform sample data words stored in a waveform register 34, the register places the color bits, included in the A sample data, on an n-bit VIDEO output bus 48, where n is the number of color bits. In the preferred embodiment n is three, allowing eight different display colors. When the count reaches the higher of the A and B sample data words, the VRS waveform register 34 deasserts its VIDEO output bus 48 and the output bus remains deasserted for the remainder of the vertical scan.

All eight of the VIDEO output busses 48 from the VRS waveform registers 34 are connected to the priority controller circuit 38. If only one of the input VIDEO busses 48 carries non-zero color bits, indicating that only one waveform image requires use of a pixel currently being scanned, then the priority circuit 38 passes the n-bit color data for the waveform to a VIDEO IN input of the clipper circuit 40. If more than one of the VIDEO output busses carries non-zero color bits, indicating that more than one waveform image is competing for the use of a currently scanned pixel, then priority circuit 38 transmits to the clipper circuit 40 only the color bits associated with the competing waveform image having the highest priority color. Since the color bits are used to control the color of a currently scanned pixel, the priority circuit 40 insures that the pixel color matches that of the highest priority waveform image so that the highest priority image appears superimposed on all of the others. If all of the waveform register outputs were merely ORed, the combination would produce unexpected display results.

The CLOCK signal from VRS controller 24 is also applied to clipper circuit 40 and each time it detects a CLOCK pulse, the clipper circuit compares the current CLOCK pulse count from VRS counter 36 with the stored clipping data C. If the count is less than or equal to the magnitude of the clipping data, the clipper circuit 40 places a binary zero on each line of an n line VIDEO OUT bus 50. If the count exceeds the magnitude of the clipping data C, then clipper circuit 40 places the color data received at its VIDEO IN input from the priority circuit 38 on the VIDEO OUT bus 50. Display controller 24 may selectively cause the clipper circuit to suppress the VIDEO OUT signal during a complete vertical scan by setting a CLIPALL bit, added to the data C word by display controller 24 before it was loaded into VRS memory 26.

Each line of VIDEO OUTPUT bus 50 is connected to an input of a separate one of n AND gates 51 while the output of each AND gate 51 is connected to an input of a separate one of n OR gates 52. A separate line of an n-bit data bus 54 from bit map circuit 32 is applied to a second input of each OR

16                                                    0206518

gate 52.  Each line of data bus 54 is also applied
to a separate input of a NOR gate 53 while the
output of NOR gate 53 is connected to a second
input of each AND gate 51.  Bus 54 carries the bit
map data for the currently scanned pixel.

When the CLOCK pulse count is greater than the
clipping data C, bus 50 carries the color bits for
the currently scanned pixel to the set of AND
gates 51.  If the pixel is not bit mapped, bus 54
will carry a binary zero on each line to every
input of NOR gate 54 and the output of gate 54 will
be high.  This high output enables AND gates 51 so
that the color bits on bus 50 are passed on to OR
gates 52.  The output of OR gates 50, applied to a
color table 58 thus also comprises the VIDEO OUT
color bits since the bus 54 inputs to gate 52 are
all zero.  The color table converts the color bits
to VIDEO OUTPUT signal code sufficient to cause CRT
driver 30 to generate the appropriate pixel color.
Color table 58 suitably comprises a read only
memory addressed by bus 56 from OR gates 52.
When a currently scanned pixel is bit mapped, the
data appearing on bus 54 is non-zero.  The output
of NOR gate 54 is low so that AND gates 51 do not
pass the color data on bus 50 to OR gate 52.  Thus
the output of OR gate 52 comprises the bit map data
on bus 54.  Therefore a graphical display, such as
a grid, may be bit mapped and superimposed over a
displayed waveform.

When the CLOCK pulse count is less than the
clipping data C, each line on bus 50 carries a
binary 0, regardless of the value of the color bits
applied to the VIDEO IN input of clipped circuit
40.  Therefore the waveform image is suppressed for
the pixels on the vertical scan line at an elevation lower than that determined by the clipping data. This feature is useful when bit mapped information is to be displayed in a pop-up window which appears to cover over a portion of the waveform rather than to be superimposed on it.

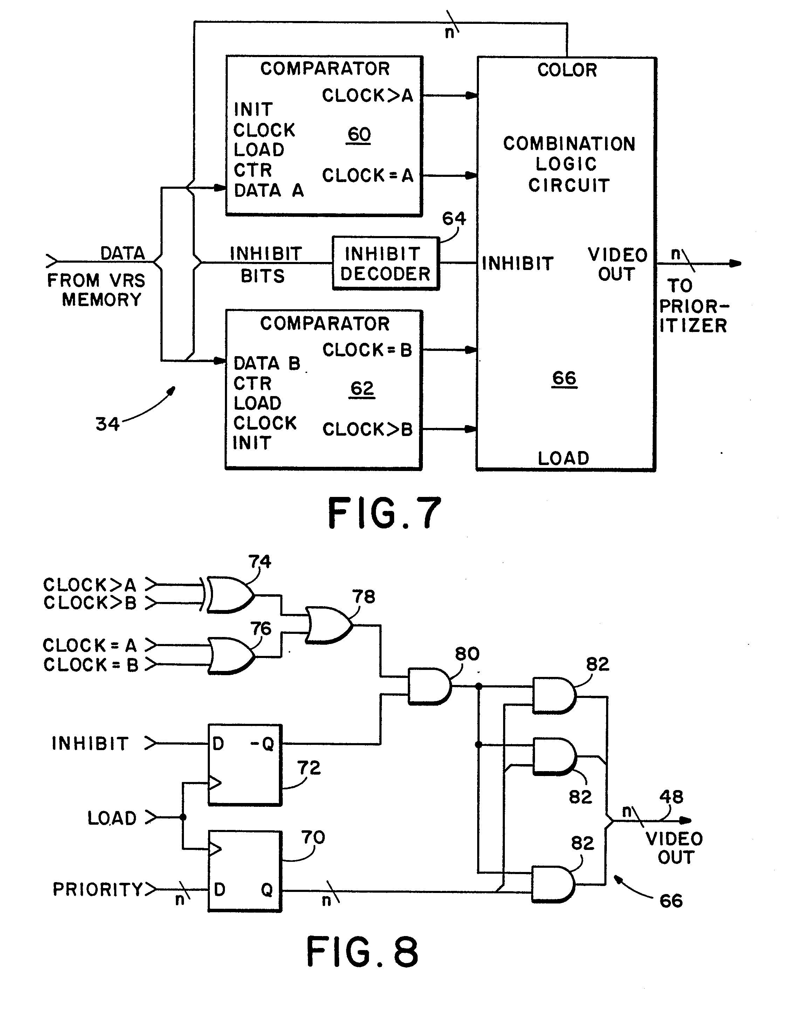

FIG. 7 is a block diagram depicting one VRS waveform register 34 of FIG. 6 in more detail. Waveform register 34 comprises an A comparator 60, a B comparator 62, an inhibit decoder 64, and a combination logic circuit 66. The A comparator asserts a CLOCK>A output signal whenever the current CLOCK pulse count CTR exceeds the magnitude of the waveform sample data A, while the B comparator asserts a CLOCK>B output signal whenever the current CLOCK pulse count exceeds the magnitude of the waveform sample data B. The A comparator also asserts a CLOCK=A signal whenever the current count equals the magnitude of data A, while the B comparator also asserts a CLOCK=B output signal when the clock count equals the magnitude of data B.

The AGE, OVER, UNDER, and NULL inhibit bits, included with the A and B waveform data, are applied to inputs of the inhibit decoder 64 which generates an INHIBIT output signal according to the states of the inhibit bits. The inhibit decoder 64 may be a read only memory addressed by the inhibit bits or a combinational logic circuit having input and output signal relations according to the following truth table, where "T" denotes that the bit is asserted, "F" denotes the bit is not asserted, and "X" denotes the bit may be in any state:

18

0206518

| INPUT INHIBIT BITS | | | | | | | | OUTPUT |
|---|---|---|---|---|---|---|---|---|
| FROM DATA A | | | | FROM DATA B | | | | |
| Age | Under | Over | Null | Age | Under | Over | Null | INHIBIT |
| F | X | X | X | T | X | X | X | T |
| T | X | X | X | F | X | X | X | T |
| X | T | X | X | X | T | X | X | T |
| X | X | T | X | X | X | T | X | T |
| X | X | X | T | X | X | X | X | T |
| X | X | X | X | X | X | X | T | T |
| (Any other combination) | | | | | | | | F |

The INHIBIT output signal of inhibit decoder 64, along with the CLOCK>A, CLOCK=A, CLOCK>B and CLOCK=B signals from comparators 60 and 64, the LOAD signal from display controller 24, and the color bits associated with the Data A word are all applied to inputs of combinational logic circuit 66. Logic circuit 66 transmits the applied color bits as the VIDEO OUT output signal of waveform register 34 whenever the CLOCK pulse count is between the magnitudes of data A and data B, provided that it is not inhibited from doing so by an asserted INHIBIT signal input from decoder 64.

The combination logic circuit 66 of FIG. 7 is depicted in more detail in block diagram form in FIG. 8. Each one of the input COLOR bits is applied to a D input of a separate one of n type D flip-flops 70. The LOAD signal is applied to a clock input of each flip-flop 70 so that at the start of a vertical scan, the color bits are latched into the Q outputs of the flip-flops 70. The INHIBIT signal is applied to a D input of another type D flip-flop 72 which is also clocked by the LOAD signal such that the inverse state of the INHIBIT signal appears at a -Q output of the flip-flop. The CLOCK>A and the CLOCK>B signals are applied to separate inputs of an exclusive OR (XOR) gate 74 while the CLOCK=A and CLOCK=B signals are applied to separate inputs of an OR gate 76. The outputs of gates 74 and 76 drive the inputs of an OR gate 78 and the output of OR gate 78 comprises one input to an AND gate 80. The -Q output of flip-flop 72 is applied to another input of AND gate 80. The output of AND gate 80 is connected in parallel to one input of each of n AND gates 82 while the Q output of each of the n flip-flops 70 is applied to a second input of a separate one of the n AND gates 82. The n outputs of AND gates 82 comprise the n-bit VIDEO OUTPUT signal of the VRS waveform register.

When either the CLOCK>A signal or the CLOCK>B signal is asserted (but not both) the output of gates 74 and 78 are high. If the INHIBIT signal is low, indicating that the VRS display is not to be inhibited, the -Q output of flop-flop 72 is high, causing the output of AND gate 80 to go high. If the color bit latched onto the Q output of any flip-flop 70 is high, the output of the associated AND gate 82 will also go high. Therefore the VIDEO output bus will carry the same bit pattern as the COLOR bit input. If both the CLOCK>A and CLOCK>B are high or both are low, indicating that the scan is outside the upper or lower digitizer limits for the current sampling interval, then the output of XOR gate 74 will be low. If either CLOCK=A or CLOCK=B input is true, indicating that the scan is on the boundary of the measurement limits for the sampling interval, then the output of gate 76 will go high, causing the outputs of gates 78, 80 and the appropriate gates 82 to go high. This ensures that if the magnitudes of data A and data B are equal, one pixel is displayed for the sampling interval. This prevents a gap in the waveform image display. If the INHIBIT signal is high, indicating that the VRS waveform display is to be inhibited, then the output of AND gate 80 will remain low so that outputs of all AND gates 82 will remain low.

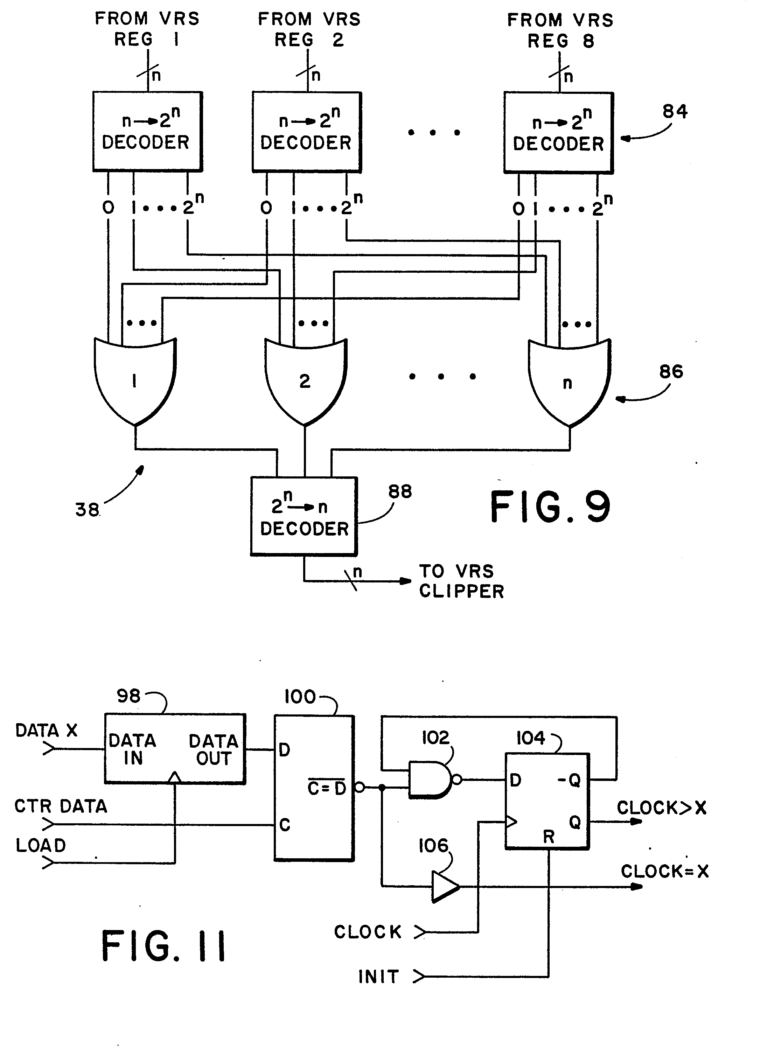

The priority controller circuit 38 of FIG. 6 is shown in more detail in block diagram form in FIG. 9. The priority circuit 38 comprises a set of $n$ to $2^n$ decoders, one for each of the m VRS registers, a set of $2^n$ OR gates 86, and a $2^n$ to n encoder 88. The VIDEO output of each VRS waveform register 34 is applied to an n bit input of a separate one of decoders 84. The ith output of each decoder 84 is applied to a separate input of the ith OR gate 86 and the output of each of the $2^n$ OR gates 86 is applied to a separate input of encoder 88. The output of encoder 88 matches the highest priority color bit input to the priority controller 38.

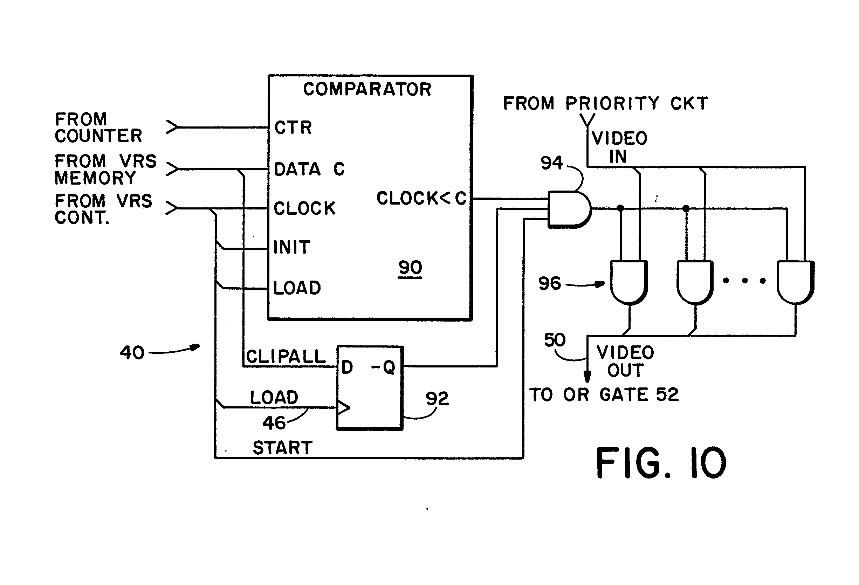

Clipper circuit 40 of FIG. 6, shown in more detailed block diagram form in FIG. 10, comprises a comparator 90 which generates a CLOCK>C signal when the clock pulse count input CTR from the counter exceeds the clipping data C from the VRS memory loaded into the comparator 90 by application of a LOAD signal from display controller 24. The CLIPALL bit, included in the data C word by the display controller prior to storage in the VRS memory, is applied to a D input of a type D flip-flop 92. A -Q output of flip-flop 92 and the CLOCK>C output of comparator 90 along with the START signal from the display controller are applied to separate inputs of an AND gate 94 and the output of AND gate 94 is applied to one input each of a set of n AND gates 96. Each bit of the color data from priority circuit 38 is applied to a second input of a separate one of AND gates 96.

When the scan reaches a pixel level above the bottom of the 512 pixel high VRS display area, exceeding the magnitude of the data C word, the output of comparator 90 is asserted, turning on AND gate 94, provided the START signal is asserted, and enabling AND gates 96. AND gates 96 then place the color data on the VIDEO IN bus from the priority circuit 38 on the VIDEO OUT bus 50 to OR gates 52. When the CLIPALL bit is set, the LOAD signal on control line 46, applied to a clock input of flip-flop 92, causes the flip-flop -Q output to go low, thereby disenabling AND gates 94 and 96 and preventing the color data from being placed on the VIDEO OUT bus 52. In such case the entire vertical pixel line is clipped. This feature may be used by the display controller to blank selected portions of the screen, such as when the waveform to be displayed does not fill the entire screen.

Referring again to FIG. 6, display controller 24 may assert a MODE control input to VRS counter 36 which causes the counter to implement a "split screen" mode wherein the counter pauses the CLOCK pulse count for 32 CLOCK pulses when it has reached a count of 256 pixels and then resumes counting until it reaches 512. This feature splits the VRS display area into two areas, leaving a 32 pixel high graphics only area in between the two VRS display areas for bit mapped graphics and text.

FIG. 11 depicts in more detailed block diagram form the comparator circuits 60, 62, and 90 used in the VRS waveform registers 34 and in a clipper

22 0206518

circuit 40 of FIGS. 7 and 10. The data A, B or C input to the comparator (designated DATA X) is applied to the input of a latch 98 and is latched onto the latch outputs when the comparator receives the LOAD signal from the display controller 24. The latch 98 output is applied to a D input of an identity comparator 100 while the current CLOCK pulse count, CTR DATA, is applied to a C input of identity comparator 100. When the magnitudes of the C and D inputs of comparator 100 are equal, comparator 100 asserts a low true output signal applied to one input of a NAND gate 102. The output of NAND gate 102 is applied to a D input of a type D flip-flop 104 while a -Q output of flip-flop 104 is applied to a second input of NAND gate 102. The CLOCK signal from the display controller 24 is applied to a clocking input of flip-flop 104 and the INIT signal is applied to a reset input R of the flip-flop.

When the INIT signal is asserted by the display controller, flip-flop 104 resets, causing its -Q output to go high. Until the CLOCK pulse count CTR reaches the magnitude of the comparator 100 input DATA X, the output of identity comparator 100 remains high and the output of the NAND gate 102 remains low. When a match occurs, the output of the comparator 100 goes low and the output of NAND gate 102 goes high. On the next CLOCK pulse, flip-flop 104 sets, causing the -Q output to go low, thereby preventing the NAND gate 102 output from going high again until the flip-flop 104 is reset by the INIT signal. The CLOCK>X signal is generated at a Q output of flip-flop 104 and the CLOCK=X signal is generated by an inverter 106 which inverts the output of identity comparator 100.

As has been described and illustrated, the vertical raster scan controller 12 of the present invention, converts stored waveform sample data pairs into a video output signal suitable for controlling vertical raster scanning CRT driver 30, permitting rapid update and indefinite storage of sampled waveform images. Its use in conjunction with a conventional bit map circuit 32 permits bit mapped graphics to be displayed on the screen without compromising the rapidity of waveform image display update.

While a preferred embodiment of the present invention has been shown and described, it will be apparent to those skilled in the art that many changes and modifications may be made without departing from the invention in its broader aspects. The appended claims are therefore intended to cover all such changes and modifications as fall within the true spirit and scope of the invention.

0206518

## Claims

1. A method for displaying on a cathode ray tube screen a representation of ordinate data as a function of a monotonic abscissa value, the method comprising the steps of:

    a. scanning said screen with an electron beam along a plurality of vertical pixel columns, each successive column corresponding to a separate monotonic abscissa value;

    b. counting pixels scanned during each column scan; and

    c. setting each pixel scanned to one selected display attribute when said pixel count lies within a range defined by magnitude data acquired during a corresponding sampling period, and to another display attribute when said pixel count lies outside said range.

2. A method for displaying on a cathode ray tube screen a representation of a waveform based on waveform magnitude data acquired during successive waveform sampling periods, the method comprising the steps of:

    a. scanning said screen with an electron beam along a plurality of vertically scanned contiguous pixel columns, each successive column corresponding to a successive sampling period;

    b. counting pixels scanned during each column scan; and

    c. setting each pixel scanned to one selected display attribute when said pixel count lies within a range defined by magnitude data acquired during a corresponding sampling period, and to another display attribute when said pixel count lies outside said range.

3. A method for displaying on a cathode ray tube screen a representation of a plurality of waveforms based on waveform magnitude data acquired during successive waveform sampling periods, the method comprising the steps of:

a. scanning said screen with an electron beam along a plurality of vertically scanned contiguous pixel columns, each successive column corresponding to a successive sampling period;

b. counting pixels scanned during each vertical scan;

c. setting each pixel scanned to a selected color when said pixel count lies within a range defined by magnitude data associated with any one of said waveforms acquired during a corresponding sampling period, said selected color being associated with said one waveform; and

d. setting each pixel scanned to a selected background color when said pixel count lies outside any said range.

4. A method for displaying on a cathode ray tube screen a representation of a waveform based on waveform magnitude data acquired during successive waveform sampling periods, and for superimposing on said waveform representation a graphics display, said the method comprising the steps of:

a. scanning said screen with an electron beam along a plurality of vertically scanned contiguous pixel columns, each successive column corresponding to a successive sampling period;

b. counting pixels scanned during each vertical scan;

c. storing data words, each such word comprising a code indicating a color of a corresponding pixel included in said graphics display and comprising a selected code when said pixel is not a part of said graphics display;

d. setting each pixel scanned to a selected color when said pixel count lies within a range defined by magnitude data acquired during a corresponding sampling period, if said corresponding stored data word comprises said selected code and said pixel count lies within said range defined by said corresponding clipping data;

e. setting each pixel scanned to a selected background color when said pixel count lies outside said data range and said corresponding stored data word comprises said selected code; and

f. setting each pixel scanned to said color indicated by said stored data word if said corresponding stored data word does not comprise said selected code.

5. The method of claim 4 wherein said selected code is zero.

6. A method for displaying on a cathode ray tube screen a representation of a waveform based on waveform magnitude data acquired during successive waveform sampling periods, and for selectively replacing portions of said waveform representation with a graphics window, the method comprising the steps of:

a. scanning said screen with an electron beam along a plurality of vertically scanned contiguous pixel columns, each successive column corresponding to a successive sampling period;

b. counting pixels scanned during each vertical scan;

c. storing data words, each such word comprising a code indicating a color of a corresponding pixel included in said window and comprising a selected code when said pixel is not a part of said window;

d. storing clipping data associated with each vertical raster scan defining a range of pixels within each said raster scan contained within said window;

e. setting each pixel scanned to a selected color when said pixel count lies within a range defined by magnitude data acquired during a corresponding sampling period, if said corresponding stored data word comprises said selected code and said pixel count lies within said range defined by said corresponding clipping data;

f. setting each pixel scanned to a selected background color when said pixel count lies outside said data range and said corresponding stored data word comprises said selected code; and

g. setting each pixel scanned to said color indicated by said stored data word if said corresponding stored data word does not comprise said selected code.

7. A method for displaying on a cathode ray tube screen a representation of a waveform based on waveform magnitude data acquired during successive waveform sampling periods, for superimposing on said waveform representation a graphics display, and for replacing portions of said waveform representation with a graphics window, said method comprising the steps of:

a. scanning said screen with an electron beam along a plurality of vertically scanned contiguous pixel columns, each successive column corresponding to a successive sampling period;

    b.  counting pixels scanned during each vertical scan;

    c.  storing data words, each such word comprising a code indicating a color of a corresponding pixel included in either said display or said window and comprising a selected code when said pixel is not a part of either said display or said window;

    d.  storing clipping data associated with each vertical raster scan defining a range of pixels within each said raster scan contained within said window;

    e.  setting each pixel scanned to a selected color when said pixel count lies within a range defined by magnitude data acquired during a corresponding sampling period, if said corresponding stored data word comprises said selected code and said pixel count lies within said range defined by said corresponding clipping data;

    f.  setting each pixel scanned to a selected background color when said pixel count lies outside said data range and said corresponding stored data word comprises said selected code; and

    g.  setting each pixel scanned to said color indicated by said stored data word if said corresponding stored data word does not comprise said selected code.

    8.  An apparatus for displaying on a cathode ray tube screen a representation of a plurality of waveforms based on waveform magnitude data acquired during successive waveform sampling periods, the apparatus comprising:

0206518

means for vertically scanning said screen with an electron beam along a plurality of contiguous pixel columns, each successive column corresponding to a successive sampling period;

means for maintaining a count of pixels scanned during each vertical scan; and

means for setting each pixel scanned to a selected color when said pixel count lies within a range defined by magnitude data associated with any one of said waveforms acquired during a corresponding sampling period, said selected color being associated with said one waveform, and for setting each pixel scanned to a selected background color when said pixel count lies outside any said range.

9. An apparatus as in claim 8 wherein said means for setting comprises:

means associated with each waveform for generating a color code corresponding to each said waveform, when said pixel count lies within a range defined by said data and for generating a background color code otherwise;

means for converting color codes to corresponding scan color control signals; and

means for receiving color codes generated by said means for generating and for transmitting a selected one of said received color codes to said means for converting when one or more of said color codes is received.

10. An apparatus for displaying on a cathode ray tube screen a representation of a waveform based on waveform magnitude data acquired during successive waveform sampling periods, and for superimposing on said waveform representation a graphics display, the apparatus comprising:

means for vertically scanning said screen with an electron beam along a plurality of contiguous pixel columns, each successive column corresponding to a successive sampling period; means for maintaining a count of pixels scanned during each vertical scan;

means for storing data words, each such word comprising a code indicating a color of a corresponding pixel included in said graphics display and comprising a selected code when said pixel is not a part of said graphics display; and

means for setting each pixel scanned to a selected color when said pixel count lies within a range defined by magnitude data acquired during a corresponding sampling period if said corresponding stored data word comprises said selected code and said pixel count lies within said range defined by said corresponding clipping data, for setting each pixel scanned to a selected background color when said pixel count lies outside said data range and said corresponding stored data word comprises said selected code, and for setting each said pixel to a color indicated by said stored data word if said corresponding stored data word does not comprise said selected code.

11. Apparatus as in claim 10 wherein said means for setting comprises:

means for generating a selected color code when said pixel count lies within a range defined by said data and for generating a background color code otherwise;

means for converting color codes to corresponding scan color control signals; and

means for receiving codes generated by said means for generating, for transmitting a selected one of said received codes to said means for converting when said corresponding stored data word is said selected code and for transmitting said corresponding stored data word to said means for converting when said corresponding stored data word is other than said selected code.

12. Apparatus as in claim 11 wherein said means for converting comprises a read only memory addressed by said color codes.

13. An apparatus for displaying on a cathode ray tube screen a representation of a waveform based on waveform magnitude data acquired during successive waveform sampling periods, and for selectively replacing a portion of said waveform representation with a graphics window, the apparatus comprising:

means for vertically scanning said screen with an electron beam along a plurality of contiguous pixel columns;

means for maintaining a count of pixels scanned during each vertical scan;

means for storing data words, each such word comprising a code indicating a color of a corresponding pixel included in said window and comprising a selected code when said pixel is not a part of said window;

means for storing clipping data associated with each vertical raster scan defining a range of pixels within each said raster scan contained within said window; and

means for setting each pixel scanned to a

32                                    0206518

selected color when said pixel count lies within a
range defined by magnitude data acquired during a
corresponding sampling period if said corresponding
stored data word comprises said selected code and
said pixel count lies within said range defined by
said corresponding clipping data, for setting each
pixel scanned to a selected background color when
said pixel count lies outside said data range and
said corresponding stored data word comprises said
selected code, and for setting each said pixel to
said color indicated by said stored data word if
said corresponding stored data word does not comprise said selected code.

14. Apparatus as in claim 13 wherein said
means for setting comprises:

first means for generating said selected
color code when said pixel count lies within a
range defined by said magnitude data and for
generating said background color code otherwise;

second means for receiving color codes
generated by said first means, for generating said
received color codes when said pixel count lies
within a range defined by said clipping data, and
for generating said background color code otherwise;

means for converting color codes to corresponding scan color control signals; and

means for transmitting color codes
generated by said second means to said means for
converting when said corresponding stored data word
is said selected code, and for otherwise transmitting said corresponding stored data word to said
means for converting.

0206518

15.  Apparatus for displaying on a cathode ray tube screen screen a representation of a waveform based on waveform magnitude data acquired during successive waveform sampling periods, for superimposing on said waveform representation a graphics display, and for replacing portions of said waveform representation with a graphics window, said apparatus comprising:

means for vertically scanning said screen with an electron beam along a plurality of contiguous pixel columns, each successive column corresponding to a successive sampling period;

means for maintaining a count of pixels scanned during each vertical scan;

means for storing data words, each such word comprising a code indicating a color of a corresponding pixel included in either said display or said window and comprising a selected code when said pixel is not a part of either said display or said window;

means for storing clipping data associated with each vertical raster scan defining a range of pixels within each said raster scan contained within said window; and

means for setting each pixel scanned to a selected color when said pixel count lies within a range defined by magnitude data acquired during a corresponding sampling period if said corresponding stored data word comprises said selected code and said pixel count lies within said range defined by said corresponding clipping data, for setting each pixel scanned to a selected background color when said pixel count lies outside said data range and said corresponding stored data word comprises said selected code, and for setting each said pixel to said color indicated by said stored data word if said corresponding stored data word does not comprise said selected code.

16. Apparatus as in claim 15 wherein said means for setting comprises:

first means for generating said selected color code when said pixel count lies within a range defined by said magnitude data and for generating said background color code otherwise;

second means for receiving color codes generated by said first means, for generating said received color codes when said pixel count lies within a range defined by said clipping data, and for generating said background color code otherwise;

means for converting color codes to corresponding scan color control signals; and

means for transmitting color codes generated by said second means to said means for converting when said corresponding stored data word is said selected code, and for otherwise transmitting said corresponding stored data word to said means for converting.

FIG. 1

FIG. 2

FIG. 3

FIG. 4

WAVEFORM AND GRAPHICS
DISPLAY AREA

23

WINDOW
AREA

25

20

21

GRAPHICS DISPLAY AREA

FIG. 5

# FIG. 6

VRS WAVEFORM REGISTER 34 #1 #8

DATA A
DATA B
CTR DATA
CLOCK  INIT  LOAD
VIDEO

FROM VRS MEMORY
DATA 42

48
n
38 PRIORITY CIRCUIT

44

VIDEO IN 40

DATA C
CTR DATA  CLIPPER CIRCUIT
CLOCK  START  INIT  LOAD  VIDEO OUT

46
n
53  50
BIT MAP DATA
54  51

36  CNT
VRS COUNTER
MODE  START  CLOCK  INIT

52

FROM DISPLAY CONTROLLER

56

12

58  COLOR TABLE  VIDEO OUTPUT

4/7

0206518

**FIG.7**

**FIG.8**

FIG. 9

FIG. 11

FIG. 10